## Europäisches Patentamt
## European Patent Office
## Office européen des brevets

(19)

(11) Veröffentlichungsnummer: **0 103 653**
**B1**

(12)  ## EUROPÄISCHE PATENTSCHRIFT

(45) Veröffentlichungstag der Patentschrift:
**10.12.86**

(51) Int. Cl.⁴: **H 01 L 21/82,** H 01 L 27/06

(21) Anmeldenummer: **82108669.1**

(22) Anmeldetag: **20.09.82**

(54) Verfahren zum Herstellen einer monolithisch integrierten Schaltung mit mindestens einem bipolaren Planartransistor.

(43) Veröffentlichungstag der Anmeldung:
**28.03.84 Patentblatt 84/13**

(45) Bekanntmachung des Hinweises auf die Patenterteilung:
**10.12.86 Patentblatt 86/50**

(84) Benannte Vertragsstaaten:
**DE FR GB IT NL**

(56) Entgegenhaltungen:
**EP - A - 0 062 883**
**DE - A - 2 449 768**
**US - A - 3 891 480**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Blossfeld, Lothar, Dipl.-Phys., Waldstrasse 23, D-7800 Freiburg-Hochdorf (DE)**

(74) Vertreter: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

## Beschreibung

Aus der DE-A- 30 09 434 ist ein Verfahren zum Herstellen einer monolithisch integrierten Schaltung mit mindestens einem bipolaren Planartransistor bekannt, dessen Emitterzone an einer Oberflächenseite eines halbleitenden Substrats in die Basiszone eingesetzt ist, welche in die Kollektorzone eindiffundiert wird. Zum Herstellen eines integrierten bipolaren Planartransistors ohne Epitaxie werden fünf Photolackmasken benötigt, welche zur Herstellung von 1. der Kollektorzone, 2. der Basiszone, 3. der Emitterzone, 4. der Kontaktöffnungen und 5. des Leiterbahnenmusters dienen. Bei diesem Verfahren wird zunächst unter Verwendung einer ersten Photolackmaske der Kollektorbereich abgegrenzt und in diesen Bereich die Dotierungen der Kollektorzone implantiert und danach diffundiert. Dann wird unter Verwendung einer zweiten Photolackmaske der Basisbereich abgegrenzt und Dotierungen der Basiszone implantiert. Anschliessend werden die Dotierungen der Emitterzone in den Emitterbereich implantiert und schliesslich unter Verwendung je einer Photolackmaske Kontaktierungslöcher in der Oberflächenseite bedeckenden Isolierschicht hergestellt und ein die Zonen kontaktierendes Leitbahnenmuster auf der Isolierschicht erzeugt.

Die Erfindung betrifft ein solches, aus der DE-A- 30 09 434 bekanntes Verfahren gemäss dem Oberbegriff des Anspruchs 1.

Da ein wesentlicher Teil der Defektraten bei der Herstellung von monolithisch integrierten Festkörperschaltungen durch Fehler bei den Photolackprozessen verursacht werden und ausserdem die Herstellungskosten von der Anzahl der Prozesse und den Defektraten bestimmt wird, ist es von grossem Vorteil, die Anzahl der Photolackprozesse so gering wie möglich zu halten, so dass neben einer Erhöhung der Ausbeute eine Verkleinerung der Strukturen und damit eine höhere Integrationsdichte möglich wird.

Für die benannten Vertragsstaaten gehört gemäss EP-A- 0 071 665 aufgrund Art. 54(3) EPÜ ein Verfahren zum Stand der Technik, das die im ersten Teil des Anspruchs 1 genannten Massnahmen umfasst und bei dem ferner folgende Verfahrensschritte durchgeführt werden:

a) Auf der Oberflächenseite des Substrats wird unter Verwendung der ersten Photolackmaske die Diffusionsmaskierungsschicht erzeugt, welche den Kollektorbereich auf dem Substrat unmaskiert lässt;

b) die Diffusionsmaskierungsschicht wird entfernt, und unter Verwendung einer zweiten Photolackmaske auf der Halbleiteroberfläche wird eine Oxidationsmaskierungsschicht erzeugt, welche den Randbereich des Basisbereichs rahmenförmig definiert und den Emitterbereich bedeckt; anschliessend werden

c) unter Verwendung der Oxidationsmaskierungsschicht und einer dritten Photolackmaske als Implantationsmaske in die freiliegende Halbleiteroberfläche mit unterschiedlichen Dotierungen Ionen des Basiszonentyps implantiert, und anschliessend wird die freiliegende Halbleiteroberfläche unter Bildung einer neuen Implantationsmaske thermisch oxidiert, wobei die implantierten Ionen aktiviert werden;

d) nach Entfernen der Oxidationsmaskierungsschicht werden unter Verwendung der neuen Implantationsmaske die Dotierungen der Emitterzone implantiert; und schliesslich

e) werden unter Verwendung einer vierten Photolackmaske die Kontaktierungslöcher geöffnet und unter Verwendung einer fünften Photolackmaske das Leitbahnenmuster hergestellt.

Aufgabe der Erfindung ist daher die Angabe eines Verfahrens gemäss dem Oberbegriff des Anspruchs 1, welches die Herstellung von integrierten Planartransistoren unter Anwendung von lediglich vier Photolackprozessen erlaubt.

Diese Aufgabe wird erfindungsgemäss durch die im kennzeichnenden Teil im Anspruch angegebenen Verfahrensmassnahmen gelöst.

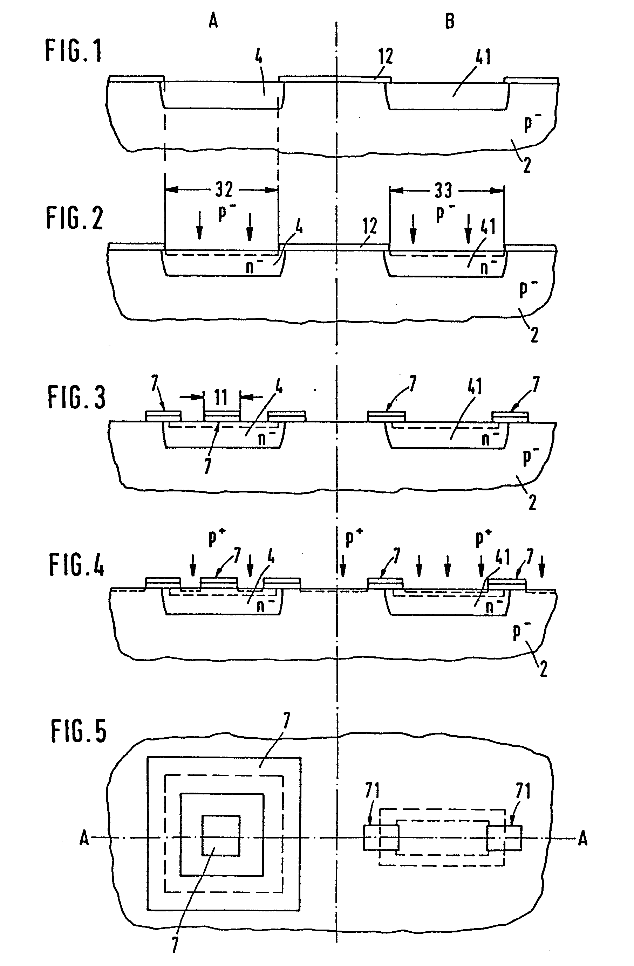

Die Erfindung und ihre Vorteile werden im folgenden anhand der Zeichnung erläutert,

deren Fig. 1 bis 7 Querschnittsansichten durch den Ausschnitt einer monolithisch integrierten Festkörperschaltung zeigt, in welchem ein bipolarer Planartransistor und ein integrierter Widerstand entsprechend einem Ausführungsbeispiel einer besonderen Ausführungsart des Verfahrens nach der Erfindung hergestellt werden.

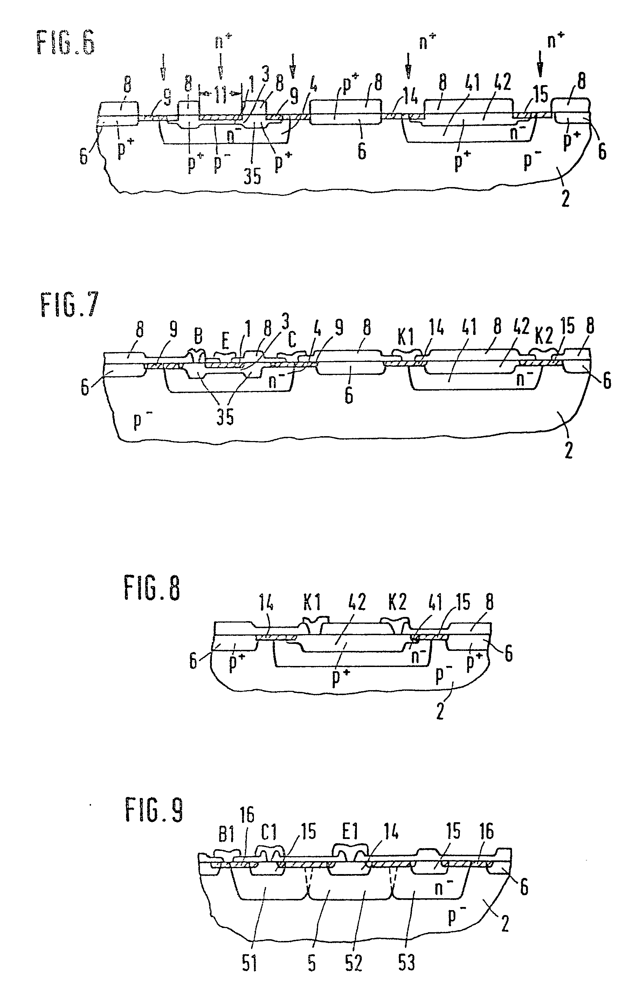

deren Fig. 8 eine weitere Ausführungsform eines integrierten Widerstandes zeigt, der mit einer besonderen Ausführungsart des Verfahrens nach der Erfindung herstellbar ist,

deren Fig. 9 als Ausschnitt einer monolithisch integrierten Festkörperschaltung die Querschnittansicht eines planaren lateralen Planartransistors veranschaulicht, der gemäss einer besonderen Ausführungsart des Verfahrens nach der Erfindung gleichzeitig mit einem vertikalen Planartransistor herstellbar ist und

deren Fig. 2a, 4a und 6a Herstellungsstadien zur Herstellung des Lateraltransistors gemäss der Fig. 9 betreffen.

Abgesehen von dem Vorteil, dass das Verfahren nach der Erfindung lediglich von vier Photolackmasken Gebrauch macht, bietet dieses Verfahren den wesentlichen Vorteil, dass es hinsichtlich der Herstellung von weiteren Schaltungselementen eine monolithisch integrierte Schaltung ohne eines Bedarfs nach einer weiteren Photolackmaske weiterbildbar ist, nämlich hinsichtlich der Herstellung von integrierten Widerständen und planaren Lateraltransistoren. Aus diesem Grunde wird bei dem im folgenden beschriebenen Ausführungsbeispiel der Figuren 1 bis 7 die Herstellung einer monolithisch integrierten Schaltung beschrieben, welche vorwiegend vertikale Planartransistoren und diffundierte Widerstände enthält. Dies ist bei einem monolithisch integrierten D/A-Wandler der Fall.

Da NPN-Planartransistoren günstigere elektrische Eigenschaften zeigen als PNP-Planartransistoren, wird vorzugsweise von einem p-dotiertem Substrat 2 ausgegangen, welches im Hinblick auf hohe Durchschlagspannungen schwach dotiert ist. Wie die Fig. 1 veranschaulicht, wird auf der Oberflächenseite des Substrats 2 eine Diffusionsmaskierungsschicht 12 erzeugt, welche entsprechend der Fig. 2 im Teil A den Basisbereich 32 des Planartransistors unmaskiert lässt und unter Verwendung einer ersten Photolackmaske hergestellt wird. Im Teil B des integrierten Widerstandes bleibt der Zonenbereich 33 einer Widerstandszone des integrierten Widerstandes frei.

Nach Entfernung der Photolackmaske wird die Oberflächenseite einem Ionenimplantationsprozess von Ionen des Dotierungsmaterials der Kollektorzone 4 bzw. der Widerstandszone 41 ausgesetzt und auf diese Weise das Dotierungsmaterial in der Halbleiteroberfläche eingebracht und eindiffundiert. Es wird eine Anordnung gemäss der Fig. 1 erhalten.

Anschliessend werden in die freigelegte Oberfläche des Substrats 2, also innerhalb des Basisbereichs 32 des Planartransistors und des Zonenbereichs 33 des integrierten Widerstandes das Dotierungsmaterial der Kollektorzone 4 und das der Widerstandszone 41 mit einer ersten relativ kleinen Dosis in die Halbleiteroberfläche mittels Ionenimplantation unter Verwendung der Diffusionsmaskierungsschicht 12 als Implantationsmaske eingebracht, so dass eine Anordnung gemäss der Fig. 2 entsteht.

Die Diffusionsmaskierungsschicht 12 wird nun entfernt und unter Verwendung einer zweiten Photolackmaske eine Oxidationsmaskierungsschicht 7 erzeugt, welche den Emitterbereich 11 und den Randbereich des Basisbereichs 32 bedeckt. Im Teil B der monolithisch integrierten Schaltung wird durch entsprechende Formgebung der zweiten Photolackmaske die Oxidationsmaskierungsschicht 7 derart ausgebildet, dass allein die Kontaktierungsbereiche 71 (vgl. Fig. 5) überlagert bleiben, welche lediglich Teile des Randbereichs des Zonenbereichs 33 bedekken. Die Oxidationsmaskierungsschicht 7 ist dagegen rahmenförmig im Randbereich des Basisbereichs 32 ausgebildet.

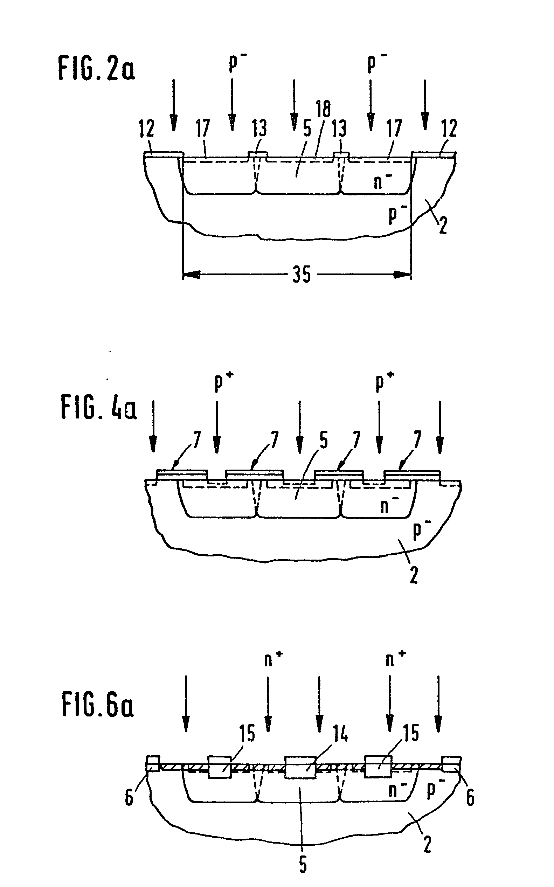

Die Fig. 4 veranschaulicht, wie anschliessend unter Verwendung der Oxidationsmaskierungsschicht 7 als Implantationsmaske in die freiliegende Oberfläche mit einer relativ hohen Dosis Ionen des Basiszonentyps in die freiliegende Halbleiteroberfläche implantiert worden sind. Die Halbleiteroberfläche ist nicht nur neben dem Emitterbereich 11 (vgl. Fig. 3) innerhalb des Basisbereichs 32 und innerhalb des Zonenbereichs 33, sondern auch zwischen den Schaltungskomponenten, also auch zwischen dem Planartransistor und dem integrierten Widerstand freigelegt, so dass nach einem Hochtemperaturprozess ebenfalls die Kanalunterbrecherzone 6 entsteht, wie die Fig. 6 bis 9 veranschaulichen. Die Fig. 5 zeigt die topologischen Verhältnisse in Aufsicht, wobei der Schnitt A–A die Fig. 4 betrifft.

Durch die relativ hohe Ionendosis des Leitungstyps der Basiszone wird erreicht, dass der innere Basiszonenbereich unterhalb des Emitterbereichs 11 über einen im vorliegendem Fall rahmenförmig ausgebildeten äusseren Basiszonenteil 35 niederohmig kontaktiert werden kann, wie die Fig. 6 zeigt.

Anschliessend wird die freiliegende Halbleiteroberfläche thermisch oxidiert, so dass relativ dicke polsterförmige Isolierschichtteile 8 aus Siliciumoxid entstehen. Diese werden als Ätzmaskierung für die Entfernung der Teile der Oxidationsmaskierungsschicht 7 verwendet. Nach Durchführung der Ätzprozesse wird eine Anordnung gemäss der Fig. 6 erhalten. Bei einem thermischen Alterungsprozess nach vorangegangener Aufbringung einer Oxidschicht werden die implantierten Verunreinigungen aktiviert und geringfügig in das Substrat 2 diffundiert. Ausser der Emitterzone 1 und der Basiszone 3 werden im Bereich unter der entfernten Oxidationsmaskierungsschicht 7 die rahmenförmige Kollektorkontaktierungszone 9, und die Kontaktierungszonen 14 mit 15 des integrierten Widerstandes gebildet.

Unter Verwendung der Dritten Photolackmaske erfolgt anschliessend die Öffnung der Kontaktierungslöcher an den zu kontaktierenden Zonen und anschliessend unter Verwendung der vierten Photolackmaske gleichzeitig mit der Ausbildung des Leitbahnenmusters das Anbringen des Emitterkontaktes E an die Emitterzone 1, des Basiskontaktes B an die äussere Basiszone 35, des Kollektorkontaktes C an die Kollektorzone 4 und der Kontakte K1 und K2 an die Kontaktierungszonen 14 und 15 des integrierten Widerstandes.

Bei dem integrierten Widerstand gemäss der Fig. 7 sind die bei der Kollektordiffusion hergestellte Zone 41 unterhalb der Oberflächenzone 42 über die Zonen 14, 15 kontaktiert. Eine andere Möglichkeit veranschaulicht die Fig. 8. Der integrierte Widerstand dieser Fig. 8 wird durch Kontaktierung der Oberflächenzone 42 mit den Kontakten K1 und K2 erhalten, wobei die Zonen 14, 15 ringförmig ausgebildet sind.

Durch das Verfahren nach der Erfindung lässt sich auch ohne weiteres ein Substrat-PNP-Transistor in einer monolithisch integrierten Schaltung herstellen. Zu diesem Zweck entfällt der Oxidationsmaskierungsschichtteil im Bereich 11 (Fig. 3) durch entssprechende Ausbildung der zweiten Photolackmaske. Demzufolge bedeckt die Siliciumoxidschicht 8 (Fig. 6) den an sich für den Emitter vorgesehenen Bereich 31. Die zum Herstellen der Kontaktierungsöffnungen vorgesehene dritte Photolackmaske wird modifiziert, so dass anstelle des Basiskontaktes B der Fig. 7 der Emitterkontakt liegt, anstelle des Kollektorkontaktes C der Basiskontakt vorgesehen ist und das Substrat 2 über eine besondere Kontaktierungsöffnung kontaktiert ist. Die vierte Photolackmaske wird entsprechend abgewandelt.

In einer besonderen Ausführungsart des Verfahrens nach der Erfindung können ausser den bisher genannten Schaltungselementen auch laterale Transistoren ohne zusätzlichen Photolackprozess und lediglich durch Modifikationen der vier Photolackmasken hergestellt werden. Ein solcher ist in der Fig. 9 in Schnittansicht dargestellt. Diese Schnittansicht lässt erkennen, dass die $n^-$-

leitende Basiszone 5 aus drei sich überlappende Teilzonen 51, 52 und 53 besteht. Die Emitterzone 14 ist von der Kollektorzone 15 umgeben und wird über die rahmenförmige Basiskontaktierungszone 16 mit dem Basiskontakt B1 kontaktiert, während an der Emitterzone 14 der Emitterkontakt E1 und an der Kollektorzone 15 der Kollektorkontakt C1 angebracht sind.

Die Herstellung des integrierten lateralen Planartransistors gemäss der Fig. 9 erfolgt entsprechend dem Grundkonzept der Erfindung gleichzeitig mit dem Planartransistor des Teils A der monolithisch integrierten Schaltung unter Verwendung der gleichen, jedoch an der Stelle des lateralen Planartransistors leicht modifizierten, vier Photolackmasken. Diese Modifikationen ergeben sich unter Zuhilfenahme der Fig. 2a, 4a und 6a.

Die Diffusionsmaskierungsschicht 12 deckt wie beim Basisbereich des Planartransistors am Rande den Basisbereich 35 des Lateraltransistors ab, jedoch bis auf stegförmige Teile zwischen den Emitterzonen 14 und der Kollektorzone 15 (vgl. Fig. 9). Die erste Photolackmaske enthält dort stegförmige Teile, so dass stegförmige Diffusionsmaskierungsschichtteile 13 entstehen. Diese werden aber so breit ausgebildet, dass bei dem im Anspruch 1 angegebenen Verfahrensschritt a, d.h. beim Diffusionsprozess zur Diffusion der Kollektorzone 4 des Planartransistors im Bereich A der Festkörperschaltung, das Dotierungsmaterial vom Leitungstyp der Kollektorzone des vertikalen Planartransistors während der Diffusion dieser Kollektorzone 4 die zusammenhängende Basiszone 5 des Lateraltransistors bildet.

Anschliessend erfolgt die Implantation des Dotierungsmaterials vom Leitungstyp der Basiszone 3 des Planartransistors entsprechend dem Verfahrensschritt a, so dass p-dotierte Oberflächenbereiche 17 und 18 nach Durchführung des Verfahrensschritt a erhalten werden. Entsprechend dem im Anspruch 1 angegebenen Verfahrensschritt b wird nun die Diffusionsmaskierungsschicht 12 mit den Diffusionsmaskierungsschichtteilen 13 entfernt und unter Verwendung der zweiten Photolackmaske, welche im Bereich des Lateraltransistors modifiziert worden ist, beim Verfahrensschritt b eine Oxidationsmaskierungsschicht 7 erzeugt, welche die Ränder des Basisbereichs des Lateraltransistors und den Kontaktierungsbereich von dessen Basiszone 5 bedeckt, wie die Fig. 4a veranschaulicht. Bei dem im Anspruch 1 angegebenen Verfahrensschritt c erfolgt nun eine Implantation von Ionen des Leitungstyps der Basiszone des Planartransistors mit der relativ hohen Dosis. Demgemäss erfolgt dann eine thermische Oxidation, wobei polsterförmige relativ dicke Oxidschichtteile entstehen, ähnlich wie es anhand der Fig. 6 geschildert wurde.

Die Halbleiterplatte der monolithisch integrierten Festkörperschaltung wird nun einem Ätzprozess zur Auflösung der Oxidationsmaskierungsschicht 7 ausgesetzt, wobei diese Schicht natürlich ebenfalls im Bereich des Lateraltransistors entfernt wird, da keine Maskierung ausser den polsterförmigen Oxidschichtteilen vorhanden ist, die während des erwähnten Oxidationsprozesses gebildet wurden. Nach der Ionenimplantation und thermischen Oxidation beim Verfahrensschritt c wird eine Anordnung gemäss der Fig. 6a erhalten.

Unter Verwendung der leicht modifizierten dritten Photolackmaske werden die Kontaktierungslöcher des Lateraltransistors geöffnet und unter Verwendung der vierten leicht modifizierten Photolackmaske das für seine Verbindung innerhalb der integrierten Schaltung erforderliche Leitbahnenmuster erzeugt. Es ergibt sich eine Anordnung gemäss der Fig. 9.

Das Verfahren nach der Erfindung hat noch den besonders zu erwähnenden Vorteil, dass integrierte vertikale Planartransistoren mit «nicht kompensierten» Emitterzonen herstellbar sind. Derartige Planartransistoren weisen besonders gute Eigenschaften hinsichtlich der Stromverstärkung und der Übergangsfrequenz $f_T$ auf, wie dem Aufsatz «Emitter Compensation Effect» in «Techn. Digest IEDM», Seiten 514 bis 516, zu entnehmen ist.

**Patentansprüche**

1. Verfahren zum Herstellen einer monolithisch integrierten Schaltung mit mindestens einem bipolaren Planartransistor, dessen Emitterzone (1) an einer Oberfläche eines halbleitenden Substrats (2) in die Basiszone (3) eingesetzt ist, welche in die Kollektorzone (4) eindiffundiert ist, bei welchem Verfahren

– unter Verwendung einer ersten Photolackmaske der Kollektorbereich mittels einer Diffusionsmaskierungsschicht (12) abgegrenzt wird und in den Kollektorbereich (32) Dotierungen vom Leitungstyp der Kollektorzone (4) implantiert und diffundiert werden,

– unter Verwendung einer zweiten Photolackmaske ein Basisbereich abgegrenzt wird und Dotierungen der Basiszone (3) implantiert werden,

– die Dotierungen der Emitterzone (1) in den Emitterbereich (11) implantiert werden und

– schliesslich unter Verwendung je einer Photolackmaske Kontaktierungslöcher in einer die Oberflächenseite bedeckenden Isolierschicht und ein die Zonen kontaktierendes Leitbahnenmuster auf der Isolierschicht erzeugt werden, gekennzeichnet durch folgende Verfahrensschritte:

a) nach der Diffusion der Dotierung vom Leitungstyp der Kollektorzone (4) aus dem Kollektorbereich (32) wird Dotierungsmaterial der Basiszone mit einer ersten relativ kleinen Dosis in die Halbleiteroberfläche mittels Ionenimplantation unter Verwendung der Diffusionsmaskierungsschicht (12) als Implantationsmaske eingebracht; danach wird

b) die Diffusionsmaskierungsschicht (12) entfernt und unter Verwendung der zweiten Photolackmaske auf der Halbleiteroberfläche eine Oxidationsmaskierungsschicht (7) erzeugt, welche den Randbereich des Basisbereichs (32) rahmenförmig definiert und den Emitterbereich (11) bedeckt;

c) unter Verwendung der Oxidationsmaskierungsschicht (7) als Implantationsmaske werden in die freiliegende Halbleiteroberfläche mit einer zweiten relativ hohen Dosis Ionen des Basiszonentyps implantiert und anschliessend die freiliegende Halleiteroberfläche unter Bildung einer neuen Implantationsmaske (8) thermisch oxidiert, wobei die implantierten Ionen aktiviert werden;

d) nach Entfernen der Oxidationsmaskierungsschicht (7) werden unter Verwendung der neuen Implantationsmaske (8) die Dotierungen der Emitterzone implantiert; und schliesslich werden

e) unter Verwendung einer dritten Photolackmaske die Kontaktierungslöcher geöffnet und unter Verwendung einer vierten Photolackmaske das Leitbahnenmuster hergestellt.

2. Verfahren nach Anspruch 1, dadurch gekennzeichnet, dass zur Herstellung eines integrierten Widerstandes

– auf der Oberflächenseite des Substrats (2) eine Diffusionsmaskierungsschicht (12) erzeugt wird, welche ausser dem Basisbereich (32) den Bereich (33) einer Widerstandszone freilässt,

– das Dotierungsmaterial der Kollektorzone auch für die Widerstandszone (41) unter Verwendung der Diffusionsmaskierungsschicht (12) als Implantationsmaske in die Halbleiteroberfläche eingebracht wird und

– beim Verfahrensschritt b) unter Verwendung der zweiten Photolackmaske eine Oxidationsmaskierungsschicht (7) erzeugt wird, welche den Randbereich des Zonenbereichs (33) an den Kontaktierungsbereichen (71) der Widerstandszone (41) bedeckt.

3. Verfahren nach Anspruch 1 oder 2, dadurch gekennzeichnet, dass zum gleichzeitigen Herstellen eines integrierten lateralen Planartransistors

– auf der Oberflächenseite des Substrats (2) eine Diffusionsmaskierungsschicht (12) erzeugt wird, welche den Basisbereich (35) des lateralen Planartransistors auf der Halbleiteroberfläche bis auf stegförmige Teile zwischen seiner Emitterzone (14) und seiner Kollektorzone (15) unmaskiert lässt, welche Teile von stegförmigen Diffusionsmaskierungsschichtteilen (13) einer solchen Breite abgedeckt sind, dass beim Verfahrensschritt a) das Dotierungsmaterial vom Leitungstyp der Kollektorzone des vertikalen Planartransistors während der Diffusion der Kollektorzone (4) des vertikalen Planartransistors (4) eine zusammenhängende Basiszone (5) des Lateraltransistors bildet,

– beim Verfahrensschritt b) nach Entfernung der Diffusionsmaskierungsschicht (12) mit den Diffusionsmarkierungsschichtteilen (13) eine Oxidationsmaskierungsschicht (7) erzeugt wird, welche die Ränder des Basisbereichs des Lateraltransistors und den Kontaktierungsbereich von dessen Basiszone (5) bedeckt und

– nach der Ionenimplantation und thermischen Oxidation des Verfahrensschrittes c) schliesslich unter Verwendung der dritten Photolackmaske die Kontaktierungslöcher des Lateraltransistors geöffnet werden und unter Verwendung der vierten Photolackmaske das für den Lateraltransistor erforderliche Leitbahnenmuster erzeugt wird.

## Revendications

1. Procédé de fabrication d'un circuit intégré monolithique comprenant au moins un transistor planar bipolaire dont la zone d'émetteur (1) est insérée dans une surface d'un substrat semi-conducteur (2), à l'intérieur de la zone de base (3), qui est diffusée dans la zone de collecteur (4), tel que:

– en employant un premier masque de laque photosensible, la région de collecteur est délimitée à l'aide d'une couche de masquage de diffusion (12), des dopants du type de conductibilité de la zone de collecteur (4) étant implantés et diffusés dans la région de collecteur (9),

– en employant un deuxième masque de laque photosensible, une région de base est délimitée et des dopants de la zone de base (3) sont implantés,

– les dopants de la zone d'émetteur (1) sont implantés dans la région d'émetteur (11), et

– finalement, en employant un masque de laque photosensible, les ouvertures de contact sont produites dans une couche isolante couvrant la surface et une grille d'interconnexion entrant en contact avec les différentes zones est produite sur la couche isolante, caractérisé en ce que:

a) après la diffusion du produit dopant du type de conductibilité de la zone de collecteur (4) dans la région de collecteur (32), le produit dopant de la zone de base, avec un premier dosage relativement faible, est introduit dans la surface du semi-conducteur au moyen de l'implantation ionique, en employant la couche de masquage de diffusion (12) comme masque d'implantation;

b) la couche de masquage de diffusion (12) west enlevée et, en employant le deuxième masque de laque photosensible, une couche de masquage d'oxydation (7) est produite sur la surface du semi-conducteur, laquelle définit la portion de bordure de la région de base (32), en forme de cadre, et recouvre en même temps la région d'émetteur (11);

c) en employant la couche de masquage d'oxydation (7) comme masque d'implantation, des ions du type de la zone de base sont implantés dans la surface exposée du semi-conducteur, avec un deuxième dosage relativement élevé, puis la surface exposée du semi-conducteur est oxydée thermiquement pour la formation d'un nouveau masque d'implantation (8), étape au cours de laquelle les ions implantés sont activés;

d) après enlèvement de la couche de masquage d'oxidation (7) et en employant le nouveau masque d'implantation (8), les dopants de la zone d'émetteur sont implantés; puis

e) en employant un troisième masque de laque photosensible, les ouvertures de contact sont réalisées et, en employant un quatrième masque de laque photosensible, la grille d'interconnexion est déposée.

2. Procédé selon la revendication 1, caractérisé en ce que, pour la fabrication d'une résistance intégrée:

– une couche de masquage de diffusion (12) est produite à la surface du substrat semi-conducteur (2), cette couche, en dehors de la région de base (32), laissant également découverte la région (33) d'une zone de résistance;

– le produit dopant de la zone de collecteur est introduit dans la surface du semi-conducteur en employant la couche de masquage de diffusion (12) comme masque d'implantation, également pour la zone de résistance (41); et

– durant l'étape de procédé b), en employant le deuxième masque de laque photosensible, il est produit une couche de masquage d'oxydation (7) qui recouvre la bordure de la région de zone (33) à l'emplacement de contact (71) de la zone de résistance (41).

3. Procédé selon la revendication 1 ou 2, caractérisé en ce que, pour la fabrication d'un transistor planar latéral intégré:

– une couche de masquage de diffusion (12) est produite à la surface du substrat semi-conducteur (2), laquelle découvre la région de base (35) du transistor latéral à la surface du semi-conducteur, jusqu'à des parties en forme de bandes entre sa zone d'émetteur (14) et sa zone de collecteur (15), ces parties étant couvertes par des parties en forme de bandes (13) de la couche de masquage de diffusion, sur une largeur telle que, au cours de l'étape de procédé a), le produit dopant du type de conductibilité de la zone de collecteur (4) du transistor planar vertical, au cours de la diffusion de la zone de collecteur (4), forme une zone de base continue (5) du transistor latéral;

– dans l'étape de procédé b), après l'enlévement de la couche de masquage de diffusion (12), avec les parties en forme de bandes (13) de la couche de masquage de diffusion, une couche de masquage d'oxydation (7) est produite, qui couvre les parties de bordure de la région de base du transistor latéral et la région de contact de sa zone de base (5), et

– après l'implantation ionique et l'oxydation thermique, dans l'étape de procédé c), et en employant le troisième masque de laque photosensible, les ouvertures de contact du transistor latéral sont réalisées et, en employant le quatrième masque de laque photosensible, on produit la grille d'interconnexion requise pour le transistor latéral.

**Claims**

1. Process for manufacturing a monolithic integrated circuit comprising at least one bipolar planar transistor whose emitter region (1) is inserted on one surface of a semiconducting substrate (2) into the base region (3), which is diffused into the collector region (4), in which process

– by employing a first photoresist mask, the collector area is restricted with the aid of a diffusion masking layer (12), and dopings of the conductivity type of the collector region (4) being implanted and diffused into the collector area (32),

– by employing a second photoresist mask, there is restricted a base area and dopings of the base region (3) are implanted,

– the dopings of the emitter region (1) are implanted into the emitter area (11), and

– finally, by employing one photoresist mask each, contact holes are produced in an insulated layer covering the surface side and an interconnection pattern contacting the regions is produced on the insulating layer, characterized by the following processing steps:

a) subsequently to the diffusion of the dopings of the conductivity type of the collector zone (4) from the collector area (32) doping material of the base region in a first relatively small dose, is introduced into the semiconductor surface by way of ion implantation and by employing the diffusion masking layer (12) for serving as the implantation masking; thereafter

b) the diffusion masking layer (12) is removed and, by employing the second photoresist mask, an oxidation masking layer (7) is produced on the semiconductor surface, which restricts the base rim portion (32) in a frame-shaped manner and covers the emitter area (11);

c) by employing the oxidation masking layer (7) as an implantation mask, ions of the base region type are implanted into the exposed semiconductor surface with a second relatively high dose rate, and subsequently thereto, the exposed semiconductor surface is thermally oxidized by forming a new implantation mask (8), in the course of which the implantes ions are activated;

d) subsequently to the removing of the oxidation masking layer (7) by using the new implantation mask (8) the dopings of the emitter zone are implanted, and finally

e) by employing a third photoresist mask, the contact holes are opened and, by employing a fourth photoresist mask, there is produced the interconnection pattern.

2. Process as claimed in claim 1, characterized in that for manufacturing an integrated resistor

– there is produced on the surface side of said substrate (2) a diffusion masking layer (12) which, apart from the base area (32) is also leaving free the area (33) of a resistor region,

– the doping material of the collector zone is also introduced for the resistor region (41) into the semiconductor surface by employing the diffusion masking layer (12) serving as an implantation mask, and

– during the processing step b), by employing the second photoresist mask, there is produced an oxidation masking layer (7) which covers the marginal or rim portion of the region area (33) at the contacting areas (71) of the resistor region (41).

3. Process as claimed in claims 1 or 2, characterized in that for simultaneous manufacturing an intergrated lateral planar transistor

– there is produced on the surface side of said substrate (2), a diffusion masking layer (12) which, with the exception of web-shaped portions between its emitter region (14) and its collector region (15), leaves the base area (35) of the lateral planar transistor unmasked on the semiconductor surface, with these portions being covered by web-shaped diffusion masking layer portions (13) in such a width that, during the processing step a) the doping material of the conductivity type of the collector region of the vertical planar transistor during the diffusion of the collector region (4) of the vertical planar transistor (4) forms a continuous base region (5) of the lateral transistor,

    – in the processing step b), following the removal of the diffusion masking layer (12), with the diffusion masking layer portions (13) there is produced an oxidation masking layer (7) which covers the base rim portions of the lateral transistor and the contacting area of the base region (5) thereof, and

    – following the ion implantation and the thermal oxidation in the processing step c), finally, by employing the third photoresist mask, the contact holes of the lateral transistor are opened and, by employing the fourth photoresist mask, there is produced the interconnection pattern required for the lateral transistor.

FIG.1

FIG.2

FIG.3

FIG.4

FIG.5

FIG.2a

FIG. 4a

FIG.6a

FIG.6

FIG.7

FIG.8

FIG.9